# EUROPEAN PATENT APPLICATION

(11) **EP 3 098 847 A1**
(43) Date of publication of application: **30.11.2016**
(21) Application number: 15305824.3
(22) Date of filing: 29.05.2015
(51) Int. Cl.: H01L 23/373, H01L 23/473

(54) **DEVICE WITH A MICROCHANNEL FOR TRANSPORTING A FLUID AND MANUFACTURING METHOD THEREOF**

(71) Applicant: ALCATEL LUCENT, 92100 Boulogne-Billancourt (FR)
(72) Inventor: Nolan, Kevin, Dublin (IE); King, Paul, Dublin (IE); Matthews, Ian, Dublin (IE)
(74) Representative: Bryers LLP

(57) **Abstract**

An apparatus, comprising a substrate having a surface and including at least one trench in the substrate and along the surface, wherein at least a portion of the at least one trench is sealed by a sealing layer, the sealing layer being formed of a stack of one or more 2D crystalline layers.

## Description

### TECHNICAL FIELD

The inventions relate, in general, to apparatus and devices and methods of making and operating such apparatus and devices.

### BACKGROUND

Exponential growth in data traffic requires greater performance from telecommunications equipment and infrastructure. This can be achieved by various technologies, such as photonics, and tighter integration of hardware in order to reduce latency, power consumption, cost and overall footprint.

Packing components that operate at high data rates in integrated packages results in significant heat fluxes, which must be effectively thermally managed. In addition photonics devices often require precise thermal control to maintain a stable spectral output.

Electronic packaging techniques typically utilize redundant parts and excess substrate boundary regions as well as operating the electronics at less than their rated values in order to manage thermal fluxes. For example, in transmitters, silicon RF transistors are typically operated below their power output capability and spaced apart from one another by relatively large separation distances in order to keep the transistors standardize operating temperatures.

### SUMMARY

According to an example, there is provided an apparatus, comprising a substrate having a surface and including at least one trench in the substrate and along the surface, wherein at least a portion of the at least one trench is sealed by a sealing layer, the sealing layer being formed of a stack of one or more 2D crystalline layers. The stack of one or more 2D crystalline layers can include one or more layers of graphene, boron nitride or a transition metal dichalcogenide. The trench and sealing layer can be configured to function as a microchannel for transporting a liquid. A light detector can be located outside the trench and configured to detect light leaving the trench via the sealing layer. A structure can be deposited over the sealing layer; and wherein the structure can be a fluid flow sensor, temperature sensor or a resistive heater. A conformal layer can be deposited on the sealing layer.

According to an example, there is provided a method for forming a device with a microchannel for transporting a liquid therein, the method comprising etching at least one trench in a substrate, depositing a sealing layer over a portion of the substrate to seal at least a portion of the trench thereby forming a microchannel with closed top, bottom and lateral side surfaces, wherein the sealing layer is formed of a material selected from one of a stack of one or more 2D crystalline layers or a topological insulator. The stack can be selected from graphene, boron nitride or a transition metal dichalcogenide. Manifolds for inputting and outputting a fluid at the ends of the microchannel can be provided. The fluid can be a gas or liquid. A structure can be deposited over the sealing layer; and wherein the structure can be a fluid flow sensor, temperature sensor or resistive heater. A conformal layer can be deposited on the sealing layer.

According to an example, there is provided a stacked CPU apparatus, the apparatus comprising at least two adjacent and stacked CPU devices, an intermediate layer with a surface, wherein the layer is arranged or interposed between the adjacent and stacked CPU devices, wherein at least a portion of the surface of the layer includes at least one trench with at least one open face adjacent to one of the CPU devices, and a sealing layer arranged on the surface between at least a portion of the open face of the at least one trench and the CPU device wherein the trench and sealing layer are configured to function as a microchannel for transporting a liquid. The at least one trench can extend through the intermediate layer, wherein to provide an open face adjacent to both CPU devices.

According to an example, there is provided a device, comprising a substrate having a surface and including at least one trench in the substrate and along the surface, wherein at least a portion of the at least one trench is sealed by a sealing layer, the sealing layer being formed of a stack of one or more 2D crystalline layers, wherein the device includes one or more devices for biological or chemical measurement. The one more devices can be optical devices such as light sources and/or light detectors and/or fluid flow or temperature sensors and/or resistive heaters for temperature trimming. The device can be a lab-on-a-chip type device.

### BRIEF DESCRIPTION OF THE DRAWINGS

Embodiments will now be described, by way of example only, with reference to the accompanying drawings, in which:
Figures 1a, 1b, 1c, 1d, and 1e are cross-sectional views illustrating a sequence of steps of a fabrication process according to an example;
Figures 2a and 2b illustrate a top view and a cross-sectional view of a microchannel cooled apparatus according to an example;
Figure 3 is a cross-sectional view illustrating a stacked CPU with 2D crystalline layer(s) that close bottom and top surfaces of trenches to form microchannels with low thermal resistance according to an example; and
Figure 4 is a schematic representation of a lab-on-a-chip device according to an example.

### DESCRIPTION

Example embodiments are described below in sufficient detail to enable those of ordinary skill in the art to make and use the systems and processes of the embodiments. It is important to understand that the embodiments can be provided in many alternate forms, and the appended claims should not be construed as being limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims are intended to be covered by the claimed inventions. Similar elements of the various embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and "including," when used herein, specify the presence of stated features, items, steps, operations, elements, and/or components, but do not preclude the presence or addition of one or more other features, items, steps, operations, elements, components, and/or groups thereof.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

Micro- and nano- channels are an enabling technology in several applications. For example, in Lab-on-a-Chip systems (so called microfluidic chips) they can be in the form of conduits through which biological and chemical media can be transported. In opto-microfluidics, micro-channels can be employed as light guides and lenses in photonics devices. In thermal management, micro-channels can be used to increase the available heat transfer surface area thereby allowing the dissipation of large heat fluxes from microelectronic and photonics devices via liquid cooling.

For economic and CMOS compatible devices, a generic substrate containing microfluidic plumbing for a wide range of components requiring thermal management is often desirable. Fabrication of these channels is typically performed through photolithography techniques. For example, a mask can be used to etch a trench, which may typically be tens to hundreds of microns wide and deep. A challenge with this approach is the step of sealing of the etched trench to form an enclosed channel.

According to an example, an apparatus includes a substrate that includes at least one microchannel for forced fluid convection cooling. The apparatus can include a semiconductor substrate, such as silicon, silicon carbide, gallium arsenide and so on, including multiple active semiconductor devices formed on or within the substrate. Such devices can include, for example, bipolar transistors for RF amplifiers and insulated gate bipolar transistors and diodes with switching applications such as power converters and so on. Alternatively, a substrate can be a glass or metallic substrate, such as a copper substrate. In either case, trenches can be chemically or mechanically etched into a surface of the substrate in order to enable the formation of sealed microchannels according to some examples.

In an example, one or more trenches can be etched in a substrate, and subsequently a sealing layer is deposited on the etched substrate to form closed microchannels from the trenches. The closed microchannels are constructed such that a fluid, such as a cooling liquid for example, can flow therethrough. In some examples, the cooling liquid is a dielectric fluid, e.g., purified water or another suitable dielectric fluid. The fluid can be gas. In an example, one or more closed-top microchannels are formed by depositing a sealing layer formed from a two-dimensional (2D) crystalline layer or a topological insulator. In such embodiments, the mechanical and thermal properties may be used to seal the etched trenches thereby producing closed microchannels.

In the above embodiments, the sealing layer may be a 2D crystalline layer, e.g., a graphene layer, a boron nitride layer or a transition metal dichalcogenide layer, such as Molybdenum Disulfide. Alternatively, the sealing layer may be a topological insulator, for example, a Bismuth Telluride layer. For the sealing layer, other multi (few)-atom-crystalline layers may be used, such as hexagonal boron nitride (hBN), other dichalcogenides, and layered oxides. Various techniques are known for the production of 2D, or thin layers of such materials (such as 10-100µm thick layers). For example, the crystalline structure of Bismuth Telluride enables mechanical exfoliation of thin samples by cleaving along the trigonal axis. The process is similar to the existing procedure for obtaining graphene from bulk graphite samples. For example, adhesive tape can be applied and removed to remove a graphene layer from a graphite substrate. In general, the processes for obtaining thin layers of the afore-mentioned materials are well known and will not therefore be described in any more detail.

In an example, a crystalline layer, such as graphene, will adhere to a substrate due to van der Walls forces. As such, one of more 2D layers of graphene, for example, deposited or otherwise provided on the surface of an etched semiconductor substrate will bond to the substrate at regions of the substrate that come into contact with the crystal. As such, etched trenches forming microchannels in a substrate can be sealed by a deposited layer or layers of a 2D crystalline layer or a topological insulator. The choice of substrate does not significantly affect the form of the deposition process for the 2D crystalline layer material. Such a sealing layer can be transferred in the same manner for various substrates, and van der Walls forces will bond the sealing layer to substrate. For example the substrate can be formed of glass or metal.

In an example, a 2D crystalline layer can be grown on a growth substrate or membrane using known techniques. Layers can be transferred to a substrate by removing from the growth substrate or membrane and laying the crystal layer on the substrate. Alternatively, the 2D-crystalline layer can be placed on the substrate while still being attached to the growth substrate or membrane, and the growth substrate or membrane can then be removed via chemical etching or by another well-known method for leaving only the 2D crystalline layer material.

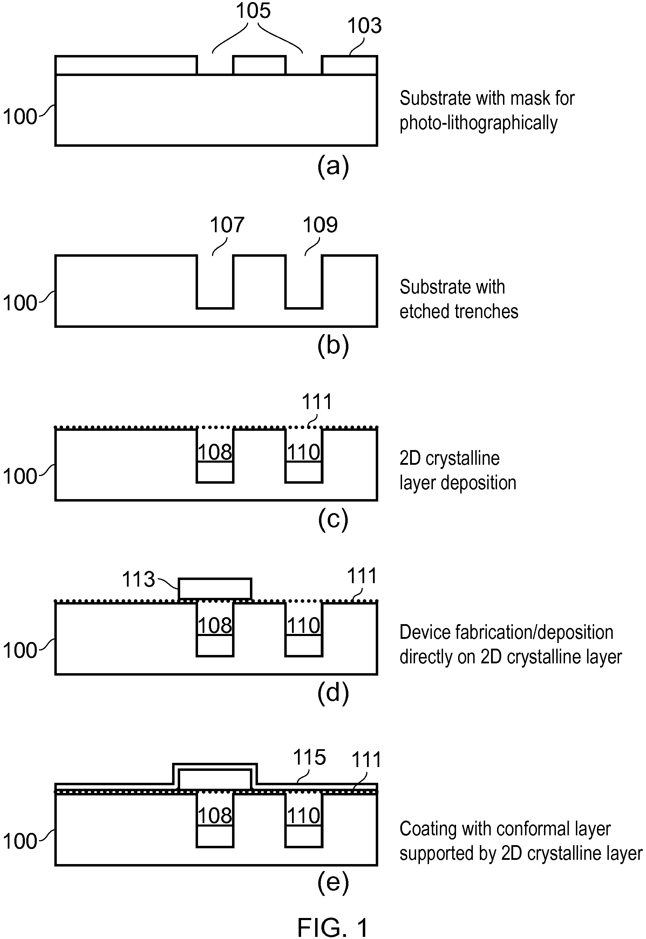

Figures 1a-e are schematic representations of a fabrication process according to an example. Particularly, figures 1a-e are schematic representations of a fabrication process for a microchannel cooled semiconductor apparatus, which may form part of a semiconductor die on which multiple such apparatus are fabricated.

In figure 1a, a substrate 100 is masked using a photomask 103. As is commonly known, a photomask can be an opaque plate with holes or transparencies 105 that allow light to shine through the plate in a defined pattern. The photomask can be used to develop the photoresist and a subsequent (wet or dry) etching process can be performed to selectively remove the developed photoresist and etch the substrate as required.

As shown in figure 1b, open trenches 107, 109 are etched into the substrate 100 to form the outline of a fluidic circuit. In figure 1c, a sealing layer 111, e.g., a 2D crystalline layer crystal, is deposited onto the substrate to seal the tops (open faces) of the open trenches 107, 109 and thereby form sealed microchannels 108, 110.

In an example, sealing layer 111 can be a monolayer of or several layers of a 2D crystal. For example, a single or multiple layers of graphene for example can be deposited. In the case of multiple layers, the individual layers therein may be deposited sequentially, or the layer 11 may be formed by a single thicker layer of crystal, which is itself formed of multiple single layers.

In an example, van der Waals bonds secure the sealing layer 111 to the surface of the substrate 100. In the case of some multi-layered crystals, van der Waals forces are known to bond the individual layers therein together. As an example, a multi-layer crystal may be a heterostructure formed of layers of respective different materials, e.g., alternating layers of graphene and hBN.

The layer 111 may be further etched to expose regions of the substrate 100 as desired. The fabrication of devices may then be performed directly onto the coated or uncoated substrate 100 as normal. For example, the sealing layer 111 can act as a scaffold allowing other layers to be deposited on top of the channel 107, 109 that would otherwise be deposited inside the channels 107, 109. This may allow, for example, metals to be deposited to form fluid flow or temperature sensors and/or resistive heaters for temperature trimming. Additional layers of suitable material may be deposited onto such a 2D crystalline layer scaffold to ensure adequate sealing of the channels 107, 109 against the effects of high pressure flows in the channels 107, 109. However, in some embodiments, the sealing layer 111 may itself provide adequate strength for most applications.

Figure 1d depicts a device 113 that has been deposited atop closed microchannel 108. In the example of figure 1d, the device 113 extends over the edges of the channel 108. But, in other embodiments, the device 113 may be only be supported by the layer 111. Figure le depicts a conformal layer 115 deposited over the device 113 and layer 111 in some embodiments.

In an example, layer 111 is substantially optically transparent. For example, the layer 111 can be up to 99% optically transparent, thereby allowing coupling of external light to a fluid or liquid in one or both of the closed microchannels 108, 110. That is, for example, device 113 can be an optical sensor that can be used to monitor fluid flow in microchannel 108. Generally speaking, the type of the crystalline layer forming sealing layer 111 may be selected as appropriate for the given application. For example, graphene has excellent electrical properties, and hBN is not electrically conductive but has excellent thermal properties. The layer 111 may reduce the thermal resistance between the device requiring cooling, e.g., the device 113, and the microchannel 108, e.g., the layer 111 may laterally spread heat from the device 113 along the top surface of the microchannel 108. Also, such a structure may be fabricated with existing micro-electronics processing techniques without the need for a 'flip-chip' step. Additionally, for example, such structures can be inexpensive, e.g., because graphene is widely available, and there exist a number of methods for the production of large sheets of graphene. Standard CMOS steps, such as device fabrication and metallic layer deposition, can be executed directly onto the microchannel 108, 110, which is top-sealed by the 2D crystalline layer 111.

Similarly to the process described above with reference to figures 1a-e, a sealing layer can be deposited onto a substrate formed from glass or metal. In either case, trenches formed in the surface of the substrate, e.g., by mechanical scoring or chemical or mechanical etching, can be top-sealed by depositing or otherwise placing a sealing layer on the substrate to produce microchannels, i.e., trenches with sealed tops.

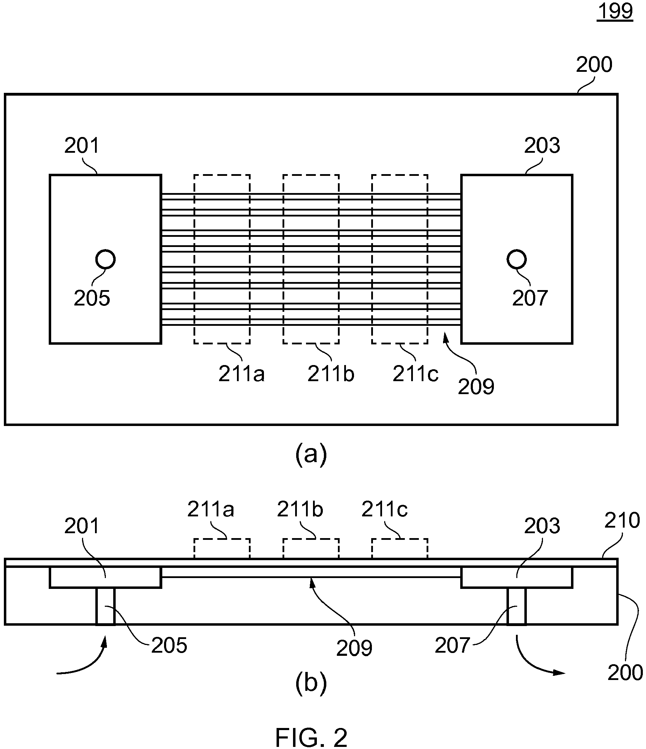

Figures 2a-b are schematic representations of a microchannel cooled apparatus according to an example. The top view, figure 2a, shows an apparatus 199 that comprises a substrate 200. Figure 2b shows a side-on view of the apparatus of figure 2a. The substrate 200 includes adjacent input and output manifolds 201, 203 with respective inlet 205 and outlet 207. Substrate 200 can be formed of semiconductor substrate, glass, or metal. Multiple microchannels 209 extend between the input and output manifolds 201, 203 to provide fluid flow paths therebetween. Devices 211a-c are fabricated or deposited over substrate 200 on a top sealing layer 210. The top sealing layer 210 may be deposited over the etched substrate 200 as described above in order to to-seal or close trenches etched into the substrate 200 and thereby form microchannels 209.

The density at which devices, such as lasers, can be packed is typically limited by thermal cross-talk. The lasers may require precise thermal trimming to maintain specular stability and neighbouring lasers can affect this. On a classical thick substrate the thermal load will spread laterally before it reaches the cooling solution. According to an example, a thermal load from lasers, for example, can be absorbed by the microchannel without spreading and the microchannels can be used to effectively isolate each device. Although the channels in figure 2a are shown running parallel to a minor axis of the devices, they can be configured to run along the major axis of a device, whereby to provide a maximum cooling effect for example.

A cooling fluid can be introduced via inlet 205 into input manifold 201. The fluid can flow along microchannels 209 to output manifold 203 where the fluid can exit the output manifold 203 via outlet 207. In an example, the fluid may be forced by an applied pressure to travel from the inlet 205 to the outlet 207. In an alternative, the fluid may flow from the inlet 205 to the outlet 207 under the action of gravity. An additional conformal layer (not shown) may be deposited over the top of the apparatus 199.

Current photonics devices, such as lasers for WDM applications generate considerable heat fluxes. For example, a laser device just 10µm wide with 100mW output can generate heat fluxes up to 1kW/cm2. Current cooling approaches use a large Thermo Electric Coolers (TEC) for thermal management and to maintain the laser stability.

Similarly power amplifiers generate very large heat fluxes and are currently cooled via complex thermal networks involving thermal pads which prevent efficient cooling of local hot spots.

The example shown in figures 2a-b for example, would allow microchannels 209 to be embedded directly below the high flux device 211a-c or hot spot with low lateral spreading of the heat.

Stacked three dimensional integrated circuits, comprising layers of processor and memory units, have been proposed for some time now. Two primary challenges that hinder development of this technology is electrical and I/O interconnects between the layers of the stacked CPU and thermal management. According to an example, a thin thermal layer can be provided between computational layers where a silicon layer is sandwiched between sheets of 2D crystalline layer(s).

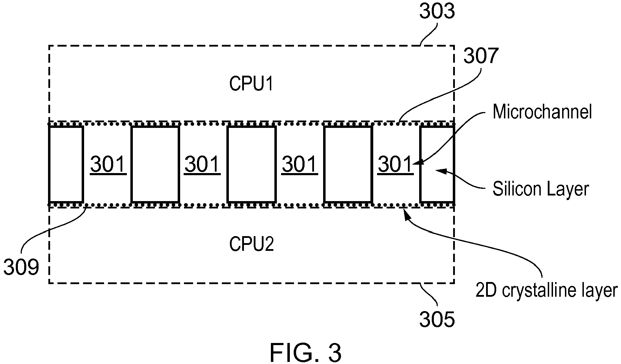

Figure 3 is a schematic representation of a stacked CPU 303, 305 with 2D crystalline layers 307, 307 that form top and bottom surfaces of microchannels for low resistance cooling. Multiple microchannels 301 are provided between the adjacent and stacked CPU devices 303, 305. More specifically, the first CPU device 303 has an adjacent sealing layer (a 2D crystalline layer) 307. The second CPU 305 has an adjacent sealing layer (a 2D crystalline layer) 309. For example, CPU 305 can have the sealing layer 309 deposited thereon and the CPU can have the sealing layer 307 deposited thereon. A layer of semiconductor material such as silicon may be located on the layer 309, and subsequently etched to form trenches for the channels 301. The second sealing layer 307 can then, be deposited over the trenches to form one surface of the microchannels 301. second CPU 303 can then, be provided on the layer 307. Accordingly, multiple ones of the microchannels 301 may be provided between the pair of stacked heat generating devices 303, 305 so that cooling fluid can be passed through the channels 301 to facilitate cooling of the devices 303, 305.

In another example, many lab-on-a-chip applications rely on light measurement as their primary means of detection. The high transparency and high strength of 2D crystalline layers, such as grapheme, may be used to allow for external optical measurements of the fluid flow in microchannels. For example, light sources and/or detectors may be placed directly above reaction zones in such microchannels to enable external optical montioring. The 2D crystalline layer may also be formed of a material suitable for electrical interconnect, e.g., for device powering and/or electrical communication.

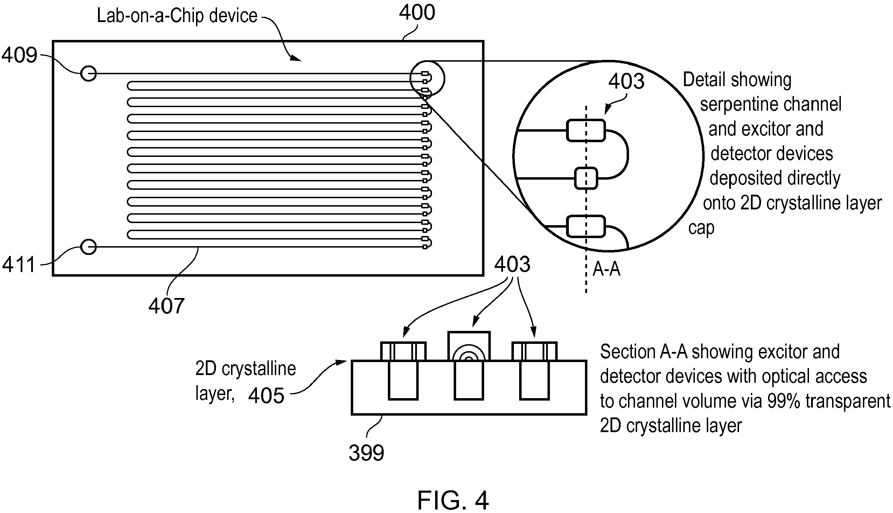

Figure 4 is a schematic representation of a lab-on-a-chip device 400 according to an example. The device 400 is a microfluidic device with embedded active optical devices 403 for biological or chemical measurement. For example, such optical devices may be light sources and/or light detectors that can be used for analyzing the progress of the polymerase chain reaction for DNA amplification. A substrate 399 for device 400 may, as explained above, be etched to provide trenches which are covered with a sealing layer 405, i.e., a 2D crystalline layer, to form serpentine microchannel 407. Input and output manifolds 409, 411 for introduction and removal of a fluid are provided. Layer 405 is, as explained above, substantially optically transparent. Accordingly, devices 403 may exchange light with the channel 407 and the fluid flowing therein so that the fluid flow and/or chemical reactions in the channel 407 may be externally monitored via the devices 403.

Thus, according to an example, there is provided a method for fabricating microchannels for high heat flux cooling technologies. Significant enhancement is obtained by the reduced resistance for heat transfer across a layer sealing one surface of channels that carry a cooling fluid. The sealing layer may be, e.g., a 2D crystalline layer such as a single layer of graphene, a graphene bilayer, or a BN layer. Such embedded microchannels may be of low cost and may be incorporated into existing CMOS fabrication, e.g., with high production yields. Accordingly, microchannel cooling may be effectively deployed in a myriad of technologies where high heat fluxes are a roadblock in future development.

Herein, some embodiments may not require additional bonding steps or flip-chip fabrication methods, and production costs of 2D crystalline layers such as graphene or BN for example may be inexpensive. According to an example, an apparatus can comprise a substrate having a surface and including at least one trench in the substrate and along the surface, wherein one surface of the at least one trench is sealed by a layer, the layer being formed of a stack of one or more 2D crystalline layers.

The present inventions can be embodied in other specific apparatus and/or methods. The described embodiments are to be considered in all respects as illustrative and not restrictive. In particular, the scope of the invention is indicated by the appended claims rather than by the description and figures herein. All changes that come within the meaning and range of equivalency of the claims are to be embraced within their scope.

## Claims

1. An apparatus, comprising:
a substrate having a surface and including at least one trench in the substrate and along the surface, wherein at least a portion of the at least one trench is sealed by a sealing layer, the sealing layer being formed of a stack of one or more 2D crystalline layers.

2. The apparatus of claim 1, wherein the stack of one or more 2D crystalline layers includes one or more layers of graphene, boron nitride or a transition metal dichalcogenide.

3. The apparatus of claim 1 or 2, wherein the trench and sealing layer are configured to function as a microchannel for transporting a fluid.

4. The apparatus of any preceding claim, further comprising a light detector located outside the trench and being configured to detect light leaving the trench via the sealing layer.

5. The apparatus of any preceding claim, further comprising a structure deposited over the sealing layer; and wherein the structure is a fluid flow sensor, temperature sensor or a resistive heater.

6. The apparatus of claim 5, further comprising a conformal layer deposited on the sealing layer.

7. A method for forming a device with a microchannel for transporting a fluid therein, the method comprising:
etching at least one trench in a substrate;
depositing a sealing layer over a portion of the substrate to seal at least a portion of the trench thereby forming a microchannel with closed top, bottom and lateral side surfaces, wherein the sealing layer is formed of a material selected from one of a stack of one or more 2D crystalline layers or a topological insulator.

8. The method of claim 7, wherein the stack is selected from graphene, boron nitride or a transition metal dichalcogenide.

9. The method of claim 7 or 8, further including:
providing manifolds for inputting and outputting a fluid at the ends of the microchannel.

10. The method of any of claims 7 to 9, further including depositing a structure over the sealing layer; and wherein the structure is a fluid flow sensor, temperature sensor or resistive heater.

11. The method of claim 10, further including depositing a conformal layer on the sealing layer.

12. A stacked CPU apparatus, the apparatus comprising:
at least two adjacent and stacked CPU devices;
an intermediate layer with a surface, wherein the layer is arranged or interposed between the adjacent and stacked CPU devices, wherein at least a portion of the surface of the layer includes at least one trench with at least one open face adjacent to one of the CPU devices; and
a sealing layer arranged on the surface between at least a portion of the open face of the at least one trench and the CPU device wherein the trench and sealing layer are configured to function as a microchannel for transporting a fluid.

13. A stacked CPU apparatus as claimed in claim 12, wherein the at least one trench extends through the intermediate layer, wherein to provide an open face adjacent to both CPU devices.

14. A device, comprising:
a substrate having a surface and including at least one trench in the substrate and along the surface, wherein at least a portion of the at least one trench is sealed by a sealing layer, the sealing layer being formed of a stack of one or more 2D crystalline layers, wherein the device includes one or more devices for mechanical, biological or chemical measurement.

15. A device as claimed in claim 14, wherein the one more devices are optical devices such as light sources and/or light detectors and/or fluid flow or temperature sensors and/or resistive heaters for temperature trimming.
